(19) Europäisches Patentamt
European Patent Office
Office européen des brevets

(11) Publication number: **0 159 942**
**A2**

(12) **EUROPEAN PATENT APPLICATION**

(21) Application number: 85400721.8

(22) Date of filing: 11.04.85

(51) Int. Cl.4: B 32 B 31/00, B 05 D 1/00

(30) Priority: 13.04.84 US 599766

(43) Date of publication of application: 30.10.85 Bulletin 85/44

(84) Designated Contracting States: AT BE CH DE FR GB IT LI LU NL SE

(71) Applicant: CHEMICAL FABRICS CORPORATION, Daniel Webster Highway P.O. Box 1137, Merrimack New Hampshire Delaware 03054 (US)

(72) Inventor: Effenberger, John A., 15 Hitching Post Lane, Bedford New Hampshire 03102 (US)
Inventor: Ribbans Robert C. III., 11 Thistle Drive, Amherst New Hampshire 03031 (US)

(74) Representative: Descourtieux, Philippe et al, CABINET BEAU de LOMENIE 55 rue d'Amsterdam, F-75008 Paris (FR)

(54) **Fluoropolymer composites and novel method for making them.**

(57) Fluoropolymer containing films (10-11) are separately formed and applied to substrates (12) to form novel composites. The invention process comprises the steps of: (1) separately forming a uniform film comprising a metered layer of a fluoropolymer containing material; (2) treating the substrate to facilitate film adhesion and bonding; (3) uniformly contacting at least one face of the film with a treated surface of the substrate; and (4) transferring the film material to the treated substrate with heat and pressure to obtain a smooth, uniform coated composite. By a decalcomania technique, the film may be cast in a single or multiple layers on a support member, such as a metal foil, drum or belt, and thereafter the face of the film opposite the support member is uniformly contacted with the substrate and transferred. The support member is thereafter removed or stripped from the film to expose the laminated composite surface. Alternatively, the film may be removed from the support member prior to contacting with the substrate.

EP 0 159 942 A2

## Description

# Fluoropolymer Composites and Novel Method for Making Them

## Background of the Invention

This invention relates to a useful method for making fluoropolymer composites as well as to composites made according to the method of the invention. The invention provides a novel method for producing reinforced composites by the application of a fluoropolymer containing film to a substrate. The resulting composites are flexible, exhibit good matrix integrity, possess excellent adhesion or bonding of the coating matrix to the substrate, and are particularly resistant to thermally induced cracking. Additionally, this invention relates to improvements in fluoropolymer coating methods by the employment of decalcomania techniques.

Conventional methods for the manufacture of coated fabrics from fluoropolymers, particularly polytetrafluoroethylene and its copolymers, include dip and knife coating from aqueous dispersion at room temperature followed by drying and sintering. The fibrous nature of textile substrates, and particularly woven fabrics, make uniform flaw-free fluoropolymer coatings very difficult and very costly to obtain. Typical defects in such coatings include microscopic bubbles and cracks. These defects arise from the inherently low critical cracking thickness associated with fluoropolymer resin formulations and are aggravated by the non-uniformity of the coating over the substrate fibers. Such cracking may be particularly noticeable upon thermal cycling during use as residual stresses attempt to relax. The natural roughness of textile substrates can result in the development of substantial mechanical

stresses in coated products prepared by conventional processes. Where the fabric is very rough and heavy or otherwise irregular such that many repeated applications are indicated to achieve a significant coating thickness, such repeated dip or knife applications can entail the development of thermomechanical stresses sufficient to crack the coatings over the weave yarns during the process itself.

Calender-coating methods, which were developed during the nineteenth century for rubber compounds, have been refined for handling plastic materials. In calender-coating, a support web is pressed against a formed plastic sheet to obtain a coated product. Practical considerations can limit the minimum film thickness to about 0.005 - 0.01 inches. In addition, variations in roll nip pressures can result in differential roll deflections leading to uneven clearances across the nip-roll face which, in turn, leads to an uneven film thickness throughout the coating. Moreover, in order to achieve acceptable adhesion between the substrate and the coating, the substrate is frequently texturized, a process which substantially weakens many textile materials. For example, texturizing fiberglass can lead to a loss of approximately one-half its strength. Calendering or melt laminating by present techniques has proven to be an ineffective process for coating fibrous webs except perhaps where perfluorinated resins of relatively low melt viscosities are employed.

Accordingly, it is an object of this invention to provide a method for preparing smooth, uniform composites which are essentially free of bubbles and cracks and which exhibit excellent thermal, mechanical, chemical and electrical properties.

It is also an object of this invention to provide a method for making fluoropolymer composites wherein

fluoropolymers, including fluoroplastics, fluoroelastomers, and blends thereof, separately and with other polymers and minerals, are cast coated and applied to a variety of substrates.

It is a further object of this invention to prepare fluoropolymer composites by decalcomania techniques.

It is a further object of this invention to provide fluoropolymer composites having outstanding thermo-mechanical properties for use as conveyer belts, release sheets, printed circuit boards, translucent architectural material, chemically resistant liners, expansion joints, low free energy surfaces, particularly for radomes, gaskets, bearings, escape chutes, and chemically protective coatings.

## Summary of the Invention

In accordance with the method of the invention, fluoropolymer-containing films are separately formed and applied to substrates. The invention process in its broadest terms comprises the steps of:

(1) separately forming a uniform film comprising a metered layer of a fluoropolymer containing material;

(2) treating the substrate to facilitate film adhesion and bonding;

(3) uniformly contacting at least one face of the film with a treated surface of the substrate; and

(4) transferring the film material to the treated substrate with heat and pressure to obtain a uniform coated composite.

In the decalcomania embodiment, the film is cast in a single or multiple layers on a support member, particularly a metal foil, drum or belt, and thereafter the face of the film opposite the support member is

uniformly contacted with the substrate and transferred. The support member may thereafter be removed or stripped from the construction revealing the laminated composite surface. Alternatively, the newly formed film may be removed from the support member prior to contacting with the treated substrate. The decalcomania technique provides a capability for fine metering of the film by means of a multiplicity of resin applications which may be chosen to individually or collectively induce a multiplicity of functions. Such metering may be accomplished most effectively through control of the solids level and viscosity of coating fluids, as well as by selection of applicator type. For example, the invention is particularly applicable to preparing a composite where deployment of various matrix materials as layers to achieve a specific geometry as desired, such as is shown in the pending application of Effenberger and Keese, Serial No. 484,594, filed April 13, 1983, and its continuation-in-part application filed April 13 , 1984.

The method of the invention may include many variations to meet special requirements. For instance, multiple coats of the same or a different material may be applied to the support member in forming the film prior to contact with the substrate. As such, the invention process enables the preparation of multi-sheet laminates with uniform electrical properties, such as dielectric constant and dissipation factor, making composites so produced particularly suitable for high performance printed circuit boards. Other support surfaces, such as release-coated paper, fibers, films and coated textile webs, may be used to carry and support the cast materials during their assembly into a metered film.

The process of the invention provides for accurate control of coating thickness and uniformity as well

as the production of an essentially flaw-free coated surface, which may be made smooth even in the case of reinforcements with prominent topographical contour. The invention process minimizes localized variability associated with press lamination of very high viscosity melts, particularly by means of a nip-roll to closely control pressure and temperature with minimal dwell time during application. In addition, the process avoids the substantial shrinkage of heat sensitive textile webs or substrates which may be encountered during conventional dip and knife coating. The invention process also provides the ability to utilize textiles with a more open mesh structure to produce essentially flaw-free composites heretofore impossible when applying less viscous fluids, as by dip coating, due to their inability to bridge the weave openings upon consolidation.

The fluoropolymer components of the film layer or layers may comprise fluoroplastics, fluoroelastomers or blends thereof, the selection of which substantially controls the fundamental mechanical and physical behavior of the composite. Fillers may be employed to modify the physical, mechanical, or electrical properties of the composites. Such fillers may include thermal and abrasion resistant polymeric materials to modify wear and frictional behavior. Mineral fillers may be used to modify dielectric properties or other physical properties such as hardness and compressibility. The contemplated thermal and abrasion resistant polymers encompass materials which are compatible with fluoropolymers and which effectively control desired properties and include, <u>inter alia</u>, polyimide, polyamideimide, polyphenylene sulfide, epoxy and polyether ketones, sulfones or imides. Any suitable mineral fillers may be used to impart known characteristics to the composite and such minerals include, <u>inter alia</u>, talc, silica, graphite, limestone, rutile and mica.

The novel reinforced composites prepared according to the invention include a substrate suitably treated to facilitate adhesion of the film, preferably a prepared textile substrate, laminated on one or both faces with a cast-coated film layer or layers of a fluoroelastomer, a fluoroplastic, or any blend thereof, either alone or further blended with (1) a polymeric material capable of imparting wear and abrasion resistance to the finished product, (2) a mineral, or any compatible blend or combination thereof.

Composites made in accordance with the invention are characterized by good matrix cohesion and strong adhesion between the prepared substrate and the fluoropolymer containing film. Significantly, the invention composites are not susceptible to thermomechanically induced stress cracking. The fluoropolymer containing films may be laminated uniformly and essentially flaw-free to a substrate in single or multiple layers to control (i) physical or mechanical properties, such as modulus, wear, friction, release and compressibility; (ii) physico-chemical properties, such as permeability, wettability, chemical resistance, bondability, cohesion, and adhesion; and (iii) electrical properties, such as dielectric constant, dissipation factor, and dielectric strength. For example, where fluoropolymer composites prepared in accordance with the invention are used to prepare printed circuit boards, such boards can have a more uniform dielectric constant and dissipation factor, and may be constructed to minimize damage induced by water permeation.

The invention provides the ability to utilize open mesh textile substrates because the weave windows are effectively bridged by the film laminate. Thus, composites prepared according to this invention, when used as architectural fabrics, for example, do not suffer from the flaws experienced with prior coated

products, such as pinholes and craters. As such, the essentially flaw-free composites of the invention are less susceptible to deterioration associated with chemical attack of the reinforcement.

The method of this invention permits the preparation of composites from components having dissimilar coefficients of expansion. The casting of the fluoropolymer containing film on foil for subsequent transfer of the film from the foil to the substrate (or decalcomania process) permits the film and substrate to be combined in a press at elevated temperatures without forming wrinkles . The decalcomania process even permits the wrinkle-free lamination of materials, such as PTFE, which can result in a wrinkled composite at the high temperatures, pressures, and lengthy residence times characteristic of commercial platen press processing.

The lamination techniques according to the invention permit facile bonding of films, comprising materials which either due to chemical composition or to the process conditions ordinarily employed to effect bonding, are viewed as wholly incompatible with the substrate compositions. For example, many thermal or abrasion resistant polymers could not heretofore be effectively bonded to an unmodified substrate. Due to the limited time/temperature exposure requirements of the lamination process according to the invention, various techniques which have been unavailable to prepare a satisfactory composite are now possible. An incompatible coating material and substrate may now be melt bonded by (1) preparing the substrate with any processible polymer or polymer blend which can serve as an adhesive, such as polymethane; (2) separately forming the coating layer or film through the graduation of polymer blends such that at least one surface of the film to be contacted with

the previously prepared surface of the substrate is rendered compatible (e.g. they both comprise compatible, readily fusible, flowable or otherwise bondable polymers at the contact faces) while the film is built up to have a surface comprising a substantial portion of the substrate incompatible component of the film whose properties are most desirable near the working or outermost surface of the composite; and (3) contacting and joining the compatible surfaces of the substrate and the graded film at or above the temperature at which the compatible layers at the interface will form a bond.

The invention also permits chemical bond attachments heretofore unattainable with many composite components. For example, it is known in the art that aminosilane coupling agents, which may be thermally labile, are particularly effective to achieve hydrolytically stable bonds between fluoropolymers and substrates, specifically fiberglass and metal. See Effenberger U.S. Patent No. 3,787,281. A preferable melt copolymer to effect such bonds is FEP, although other copolymers with TFE are suitable. Prior processes have been ineffective where process temperatures and dwell times result in an oxidative or thermally induced loss of bonding. The invention process can effectuate, at relatively low temperatures, a hydrolytically stable bond between e.g. an aminosilane-treated fiberglass substrate and an FEP or KEL-F containing film the main components of which might comprise a much higher melt viscosity polymer, such as PTFE.

In those embodiments of the invention where a substrate is laminated with a certain matrix on only one face, the substrate may be adhered to a different film matrix on its other face. Moreover, composites made according to the invention may exhibit a top

coat containing any desired layer or layers of a fluoroelastomer, a fluoroplastic or any blend or combination thereof, along with other polymers or minerals which may be different in composition from the underlying layer or layers.

In addition, relatively small amounts of crosslinking accelerators, such as triallyl isocyanurate, triallyl imidazole, and the like, may be used to crosslink one or more of the resins contained in the mating layers, as desired, by use of high energy electrons or actinic irridation.

Any suitable reinforcement material capable of withstanding processing temperatures and treated where necessary to facilitate bonding of the films laminated thereto may be employed as a substrate. Examples of suitable reinforcement materials include, inter alia, glass, fiberglass, ceramics, graphite (carbon), PBI (polybenzimidazole), PTFE, polyaramides, such KEVLAR and NOMEX, metal such as copper or steel wire, polyolefins such TYVEK, polyesters such as REEMAY, polyamides, polyimides, thermoplastics such as KYNAR and TEFZEL, polyphenylene sulfide, polyether oxides, polyether sulfones, polyether ketones, novoloid phenolic fibers such as KYNOL, cotton, asbestos and other natural as well as synthetic textiles. The substrate may comprise a yarn, filament, monofilament or other fibrous material either as such or assembled as a textile, or any woven, non-woven, knitted, matted, felted, etc. material.

A substrate material useful in the practice of the invention comprises any reinforcement which has been treated as necessary to facilitate adhesion with the fluoropolymer containing film. This treatment may be accomplished in a variety of ways. For example, a reinforcement, such as fiberglass, may be treated with a melt adhesive, such as FEP, PFA or the various KEL-F polymers.

Depending upon the nature of the substrate and the intended end use of the composite, the reinforcement or substrate maybe impregnated, either initially or simultaneously with the initial polymer layer, with a suitable lubricant or saturant, such as methylphenyl silicone oil, graphite, or a highly fluorinated fluid and the like. The lubricant or saturant performs three functions vis a vis the reinforcing substrate:

(1) as a lubricant, it protects the substrate from self-abrasion by maintaining the mobility of the reinforcing elements;

(2) as a saturant, it inhibits extensive penetration of the initial polymer coat into the substrate which could reduce flexibility; and

(3) in a finished product, it remains in the substrate to inhibit wicking of moisture or other degrading chemicals through the substrate. The lubricant or saturant may either be applied separately as an initial pass or in combination with the application of the polymeric component.

The use of cast-coated film according to the invention permits the production of coated composites having surfaces with a more uniform coating thickness than those obtained in dip coating. The fluoropolymer coating may be constructed in any required thickness with a minimal number of operations. The composites so prepared may exhibit the surface smoothness of the cast film support member with essentially flaw-free bridging of weave windows in the case of open mesh fabrics. The cast-coated film layers are dimensionally stable when laminated since they are applied to the substrate without stretching and may be annealed on the film forming support member during and after the fusing operation. Moreover, cast-coated films may not require the surface release agents frequently required in a calender coating process. By use of

multiple coating heads in conjunction with the support belt, a composite coating may be provided with a stiff or tough outer surface and a compliant under layer to provide low modulus characteristics. This is especially useful in providing a composite with good ice-releasing characteristics. The method of this invention provides an accurate control of coating thickness and the production if desired of smooth coated surfaces regardless of the topographical contours, i.e. roughness or irregularity, associated with the substrate.

In accordance with one embodiment of the invention, physical variability of the matrix associated with commercial platen press lamination methods is avoided by the employment of a nip-roll laminating press whereby the gap and pressure at the junction of the cast film and substrate may be independently controlled so that the composite is formed at minimal pressure with the constituent elements present for only a brief time at interfacial fusion temperatures. Accordingly, composites can be constructed more quickly utilizing adhesives which have lower melting points than that of major resin constituents. Substrates, such as polyester, which would be damaged in a dip-coating operation, will not necessarily suffer thermal degradation when coated according to the method of this invention. The use of the nip-roll also permits the manufacture of composites which would have otherwise been destroyed in a platen press at elevated temperatures for the usual time periods now common to such a process.

The decalcomania feature of this invention may be employed in any traditional lamination coating method such as hot calendering, extrusion coating, platen pressing and cast coating. The decalcomania technique not only avoids wrinkles, but also permits

the lamination of materials, such as PTFE or high molecular weight FEP, in a relatively stress-free condition thereby minimizing the introduction of melt memory to the polymer, the presence of which is virtually unavoidable in present platen press processes. In a printed circuit board application, the use of the decalcomania process minimizes mechanical stress in a fluoropolymer composite, thus providing a material which is dimensionally more uniform upon thermal cycling.

Detailed Description

The term "fluoroplastic" as used herein encompasses both hydrogen-containing fluoroplastics and hydrogen-free perfluoroplastics, unless otherwise indicated. Fluoroplastic means polymers of general paraffinic structure which have some or all of the hydrogen replaced by fluorine, including, inter alia, polytetrafluoroethylene (PTFE), fluorinated ethylene propylene (FEP) copolymer, perfluoroalkoxy (PFA) resin, homopolymers of polychlorotrifluoroethylene (PCTFE) and its copolymers with TFE or $VF_2$, ethylene-chlorotrifluoroethylene (ECTFE) copolymer and its modifications, ethylene-tetrafluoroethylene (ETFE) copolymer and its modifications, polyvinylidene fluoride (PVDF), and polyvinylfluoride (PFV).

Similarly, the term "fluoroelastomer" as used herein shall encompass both hydrogen-containing fluoroelastomers as well as hydrogen-free perfluoroelastomers, unless otherwise indicated. Fluoroelastomer means any polymer with elastomeric behavior or a high degree of compliance containing one or more fluorinated monomers having ethylenic unsaturation, such as vinylidene fluoride, and one or more comonomers containing ethylenic unsaturation. The fluorinated monomer may be a perfluorinated mono-olefin, for example hexafluoropropylene,

pentafluoropropylene, tetrafluoroethylene, and perfluoroalkyl vinyl ethers, e.g. perfluoro (methyl vinyl ether) or (propyl vinyl ether). The fluorinated monomer may be a partially fluorinated mono-olefin which may contain other substituents, e.g. chlorine or hydrogen. The mono-olefin is preferably a straight or branched chain compound having a terminal ethylenic double bond. The elastomer preferably consists of units derived from fluorine-containing monomers. Such other monomers include, for example, olefins having a terminal ethylenic double bond, especially ethylene and propylene. The elastomer will normally consist of carbon, hydrogen, oxygen and fluorine atoms.

Any fluoropolymer component may contain a functional group such as carboxylic and sulfonic acid and salts thereof, halogen, as well as a reactive hydrogen on a side chain.

Preferred elastomers are copolymers of vinylidene fluoride and at least one other fluorinated monomer, especially one or more of hexafluoropropylene, pentafluoropropylene, tetrafluoroethylene and chlorotrifluoroethylene. Commercially available fluoroelastomers include copolymers of vinylidene fluoride and hexafluoropropylene, such as Viton A, sold by DuPont; terpolymers of vinylidene fluoride, hexafluoropropylene and tetrafluoroethylene, such as Viton B sold by DuPont (and similar copolymers sold by 3M as FLUOREL, by Daiken as DAIEL, and by Montefluous as TECHNIFLON), and copolymers of vinylidene fluoride and chlorotrifluoroethylene, such as Kel-F sold by 3M. The use of AFLAS, which is a copolymer of TFE and propylene, as manufactured by Asahi, is also contemplated.

Preferred perfluoroelastomers include elastomeric copolymers of tetrafluoroethylene with perfluoro (alkyl vinyl) comonomers, such as hexafluoropropylene

or perfluoro (alkyl vinyl ether) comonomers represented by

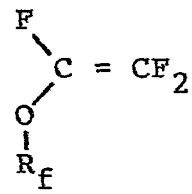

in which $R_f$ is a perfluoroalkyl or perfluoro (cyclooxa alkyl) moiety. Particularly preferred are the perfluorovinyl ethers in which $R_f$ is selected from the groups $-CF_3$, $-C_3F_7$,

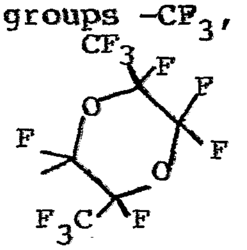

, or $-[CF_2CF(CF_3)]_N OCF_2CF_2SO_2X$.

where N = 1-4, X = H, Na, K or F. KALREZ, a copolymer of TFE and perfluoromethylvinyl ether (PMVE), or its modifications, is a particularly useful fluoroelastomer.

The term "polyimide" as used herein encompasses

$$= N - R_1 - N = R_2 =$$

where $R_1$ is a diamide and $R_2$ is a dianhydride.

The term polyamidimide as used herein encompasses

$$-\underset{H}{N} - R_1 - N = R_2$$

wherein $R_1$ and $R_2$ have the same meaning as above.

If desired, and as is well-known in the art, fillers or additives such as pigments, plasticizers, stabilizers, softeners, extenders, and the like, can be present in the matrix composition. For example, there can be present substances such as graphite, carbon black, titanium dioxide, alumina, alumina trihydrate, glass fibers, beads or microballoons, carbon fibers, magnesia, silica, asbestos, wall-astonite, mica, and the like.

In the method according to the invention, the fluoropolymer containing film matrix, which may

comprise one or more layers of varying content, is prepared separately. The independent formation of the film permits development of a uniform, low stress, finely metered layer prepared specifically for subsequent application to the substrate. The most preferred technique for preparing the film is casting in preparation for decalcomania transfer or fusion roll lamination. In such a technique, the film is formed upon a support member which may be any dimensionally stable membrane, such as a metal foil, particularly aluminum foil, or a compatible polymeric film, such as skived PTFE or KAPTON polyimide film. Other techniques for film formation include melt extrusion or coextrusion and calendering.

In most instances, the substrate must be treated in a suitable manner to facilitate reception, bonding, and durable adhesion of the film layer. As previously indicated, due to the favorable time-temperature limitations of the lamination process of the invention, the substrate may be treated with effective coupling agents and melt adhesives to accomplish durable bonding.

The contact of the compatible faces of the substrate and film layer or layers is accomplished by any known means which will effectively promote a uniform juxtaposition of the film and the substrate, such as by a fusion roll laminator. Similarly, the transfer step may be accomplished in a single operation under relatively low temperature and pressure conditions to obtain a smooth, uniform and essentially flaw-free composite. The production of a metallic layer as a surface or internal matrix component in the final composite may be accomplished by incorporating a metal foil or metallized film in the invention process. Such composites would be particularly useful as selective optical shutters or printed circuit boards.

Brief Description of the Drawings

The present invention will be further described with reference to the accompanying drawings, in which:

FIG. 1 is a schematic view of a nip roll laminator operation for preparing a composite according to the invention;

FIG. 2 is an illustrative view in cross section of a multi-layered film separately cast on a metal foil support member;

FIG. 3 is an enlarged view in cross section of a finished composite according to the preferred embodiment of the invention;

FIG. 4 illustrates the retention of fabric tensile strength after exposure to boiling 2 N sulfuric acid for periods of time up to two weeks.

FIG. 1 illustrates the simultaneous, continuous lamination of a supported film to both sides of a web or substrate. A treated substrate 12 is rolled off an un-wind 14 and travels through a preheat oven 16 to the nip rolls 18. The preheat oven 16 raises the substrate temperature sufficiently to enable melt adhesion to previously formed films 10 and 11 being removed from un-winds 20 and 21, respectively. The films 10 and 11 may be unsupported or they may have metal foil backing attached to them, as seen in FIG. 2. The nip rolls 18 apply sufficient pressure to achieve adhesion and effect a laminate 24 which is continuously formed and folled onto a wind up 26. Where the films 10 and 11 are supported by a metal foil backing, the foil would remain on the laminate at wind-up 26. The foil would thereafter be removed in another processing step (not shown) to achieve a finished laminate if the metal is undesirable in the finished product. If the films 10 and 11 are unsupported, then a carrier free laminate would appear at wind up 26; as desired, a subsequent metal foil lamination or metallization

process could then be used to produce a metal surface on the finished product.

FIG. 2 illustrates a multilayered film cast on a metal support or backing 34. The layers are cast in reverse order from that in which they are to be deployed in the composite. For example, the first layer 30 in the film 32 is formed directly adjacent to the foil 34 and will serve as the composite surface e.g. PTFE. The intermediate layer 36 may comprise a fluoropolymer/hard polymer blend, while the top layer 38 is that which will be directly applied to the substrate and should be compatible with it either as such or in a modified form.

An enlarged view of a finished composite is shown in FIG. 3. The woven fabric substrate 13 of the composite according to this embodiment has been laminated on both sides with film layers 10 and 11.

In Fig. 4, a composite coated by conventional dip coating techniques is labelled "O" on the chart. The same fabric coated by the method of this invention is labelled "X". After one week in boiling 2N sulfuric acid the conventionally coated fabric "O" retained 60% of the original tensile strength, while the cast coated fabric "X" retained 76% of the original tensile strength. After 2 weeks exposure in boiling 2N sulfuric acid, the strength retention was 59% for the "X" composite and 47% for the "O" composite.

The invention and its advantages are also illustrated by but not limited to the following examples. The following table sets forth a description of the various property tests employed in the examples.

| PROPERTY | | TEST PROCEDURE |
|---|---|---|
| Weight (oz/sq yd) | | FED STD 191-5041 |
| Thickness (ins) | | FED STD 191-5030 |
| Tensile Strength (lbs/in) | Warp<br>Fill | FED STD 191-5102 |
| Trapezoidal Tear Strength (lbs) | Warp<br>Fill | FED STD 191-5136 |
| Coating Adhesion (lbs/in) | Dry<br>Wet | * |
| Dielectric Strength (volts) | | ASTM D-902 |
| Hot Acid Exposure (%) | | ** |
| Permeability to CO | | *** |

* This test measures the adherance of the coating matrix to a substrate by subjecting a specimen (prepared from two pieces of the sample composite joined face to face as in making a production type joint or seam) to an Instron Tester, Model 1130, whereby the pieces forming the specimen are spearated for a specified length (3") at a specified rate of strain (2"/min.). The average reading during separation is deemed the adhesion value in lbs./in.

** These tests measure the tensile strength retained by materials exposed to hot sulfuric acid for various lengths of time. A number of cut rectangles are suspended in the indicated environments, with cut edges exposed. At the stated intervals, specimens are removed and tensile strength measured. The results are reported as percent tensile strength retained after exposure.

*** This test measures the permeability of a membrane to carbon monoxide. A membrane sample is cut to cover the open space between two chambers positioned horizontally one over the other and clamped in place with suitable gaskets to prevent leakage. The pair of chambers is either 12 1/2 inches in diameter or 5 5/8 inches in diameter depending upon the available sample size. Nitrogen gas containing 2% carbon monoxide is purged through the bottom chamber at a flow rate of 5.8 cu. ft./day (ambient conditions). Pure nitrogen gas is purged through the top chamber at 15.3 cu. ft./day at (ambient conditions). The steady state carbon monoxide level in the nitrogen gas stream emerging from the top chamber due to permeation through the test membrane or composition is determined by means of a CO analyzer, Series 2000 made by Energetics Science Corp. and is recorded as parts per million CO.

Example 1

Style 1080 fiberglass fabric was coated to 3.10 oz./yd.$^2$ with PTFE derived from TE-3313 (DuPont) followed by a coat (0.5 oz./yd.$^2$) of FEP derived from TE-9503 (DuPont). PTFE derived from TE-3313 was cast on aluminum foil to a thickness of 1-2 mils. Both sides of the coated fabric were laminated with the fluoropolymer coating at 200-300 psi (calculated on the samples) and 650°F for 1 min. The resulting

composite weighed 6.3 oz./yd.$^2$ and had a dielectric strength of 6500 volts (1/4 in. electrode) which is very high for so thin a composite.

Example 2

Chemfab fiberglass fabric, Style 121, was primed with a PTFE/silicone oil mixture and laminated by a decalcomania process on both sides with a PTFE film weighing 1.5 oz./yd.$^2$ which was derived from TE-3313 under the same conditions as Example 1. The resulting composite weighed 9.5 oz./yd.$^2$ and had a dielectric strength of 6500 Volts. The high dielectric strength was surprising since such a value is not usually obtained for composites preared by dip-coating processes below a weight of 12 oz./yd.$^2$. Additionally, the coating adhesion was found to be high and such coating could not be manually peeled away from the substrate.

Example 3

Style 1528 fiberglass fabric was coated with a PTFE/silicone mixture comprising 42.9% weight PTFE derived from TE-3313, 53.3% water and 3.8% methylphenyl silicone oil) derived from ET4327 (Dow-Corning). The primed substrate was then coated with carbon-filled PTFE to increase electrical conductivity. The substrate was laminated to carbon-filled PTFE cast-coated onto foil under the same conditions as Examples 1 and 2. After transfer of the decal material for the foil to the prepared fiberglass substrate, the foil was removed. The resulting composite weighed 14.0 oz./yd.$^2$ and its surface resistance measured 20,000 ohms/sq.

Example 4

Style 1528 glass fabric was treated in accordance with the method of Example 3 and laminated on one side with the carbon-filled PTFE/aluminum decal material

of Example 3. Lamination conditions were the same as those employed in Examples 1-3. Upon removal of the foil, the resulting composite weighed 12.6 oz./yd.$^2$ and had a surface resistance of 32,000 ohms/sq.

Example 5

Chemfab Style 129 glass cloth was coated with PTFE derived from TE-3313 to yield a prepared substrate weighing 7.53 oz./yd.$^2$. PTFE cast films were laminated to both sides of the treated substrate under the same conditions as Examples 1-4. The resulting composite weighed 10.6 oz./yd.$^2$ and had a thickness of 8.6 mils. The composite was tested and the following results were obtained:

| | |
|---|---|
| Dielectric Strength | |
| 1/4 in. electrode | 5200 volts |
| 2 in. electrode | 4100 volts |
| Trapezoidal Tear Strength | |
| Warp | 25 lbs. |
| Fill | 28 lbs. |
| Tensile Strength | |
| Warp | 310 lbs./in. |
| Fill | 330 lbs./in. |
| Coating Adhesion | 7.4 lbs./in. |

Example 6

Style 2113 glass cloth was dip-coated with 1.07 oz./yd.$^2$ of PTFE derived from TE-3313 and fused at 700°F. The greige fabric weight was 2.38 oz./yd.$^2$ and the coated fabric weight was 4.45 oz./yd.$^2$. Three coats of PTFE derived from TE-3313 were coated onto a 1 mil aluminum foil. The polymer face of the decal material was laminated to the previously coated 2113

fabric at 670°F. After the foil was peeled away, the following properties were measured on the composite:

| PROPERTY | UNITS | VALUES |
|---|---|---|
| Weight | oz./yd.$^2$ | 7.8 |
| Thickness | mil. | 5.2 |
| Dielectric Strength | volts | |
| 1/4 in. electrode | | 7,300 |
| 2 in. electrode | | 6,000 |
| Carbon Monoxide Permeability | ppm. | 4 |
| Trapezoidal Tear Strength | lbs. | |
| Warp | | 5.8 |
| Fill | | 1.4 |
| Tensile Strength | lbs. | |
| Warp | | 210 |
| Fill | | 100 |
| Coating Adhesion | lbs./in. | 7.2 |

Both the dielectric strength and the carbon monoxide permeability of Example 6 are outstanding. For a 1/4 in. electrode, the typical value for dip-coated PTFE fiberglass composites of this type is about 5,000 volts. With respect to carbon monoxide permeability, values approaching 10 ppm can only be acheived by subsequent additional coatings to heal microcracks in conventionally dip-coated composites.

Example 7

Style 2133 glass fabric was laminated to a PTFE coated foil in a press at 650°F for one hour under 1,000 psi. The following properties were measured:

| PROPERTY | UNITS | VALUES |
|---|---|---|
| Weight | oz./yd.$^2$ | 7.75 |
| Thickness | mil. | 5.1 |
| Dielectric Strength | volts | |
| 1/4 in. electrode | | 580 |
| 2 in. electrode | | 440 |
| Trapezoidal Tear Strength | lbs. | |
| Warp | | 4.5 |
| Fill | | 1.1 |
| Tensile Strength | lbs./in. | |
| Warp | | 240 |
| Fill | | 93 |
| Coating Adhesion | lbs./in. | 3.7 |

Example 8

Style 2113 glass fabric was coated with the PTFE/silicone formulation of Example 3. Aluminum foil (1 mil) was coated with PTFE derived from TEFLON 30B followed by two coats of a PTFE/PPS formulation (71%/29% by weight). Transfer of this decal intermediate was achieved by lamination at 650°F with subsequent removal of the foil. The resulting composite was 1.4 mils thick.

Example 9

Three layers of PTFE derived from TEFLON 30B were cast onto aluminum foil and the resulting decal was laminated to the prepared substrate as set forth in Example 8. The composite had a thickness of 4.2 mils.

Example 10

A PTFE coated aluminum foil (0.4 mil) top coated with 0.05 mil FEP was prepared as a decal and subsequently laminated at 330°C to both sides of a non-woven glass cloth (9 mil. thick) obtained from Electrolock Inc. (Chagrin Falls, Ohio). The non-woven glass cloth was prepared for lamination by saturating with FEP derived from TE-9503 and drying. The resulting composite was tough, flexible and tear resistant and was not brittle. It had a thickness of 10 mils and could be folded on itself without breaking.

Example 11

An otherwise similar composite coated according to conventional dip-coating methods was prepared along with a composite made in accordance with the method of this invention (Example 8). Both were cycled from room temperature to 500-600°F, 100 times by alternately exposing them to a hot plate and a room temperature water bath. Both composites were examined microscopically. The composite of Example 8 maintained its matrix integrity and exhibited no surface discontinuities, while the composite prepared according to conventional dip-coat procedures exhibited numerous microscopic cracks. The cracks were located predominently over the tops of and parallel to the woven yarns. Unlike the composite prepared in accordance with conventional procedures, the invention composite according to Example 8 was resistant to stress cracking upon thermal cycling.

Example 12

Chemfab style 122 glass fabric was prepared by heat cleaning and coating with the PTFE/silicone oil formulation of Example 3 to a total weight of 41.4 oz. A PTFE film of 1.2 mils thickness was prepared on aluminum foil by casting at or above 660°F. and

stripping it from the foil. Five layers of this film were laminated to each side of the prepared fabric. The resulting composite was immersed in 2N sulfuric acid at 103°C for two weeks along with a similar composition prepared by conventional dip-coating techniques. Figure 4 illustrates the results. The sample prepared by this invention is labelled X and the conventionally coated fabric O. After one week in the boiling acid composite X retained 76% of the original strength while conventionally dip-coated fabric O retained 60%. After two weeks, the composite prepared by this invention X retained 59% of the original strength while the conventionally coated fabric O retained 47% of the original strength.

It is to be noted that Style 122 glass fabric is characterized by a prominently contoured topography and relatively large openings.

Example 13

Chemfab Style 1590 KEVLAR fabric weighing 4.0 oz./yd.$^2$ was coated with ca. 6.5 oz./yd.$^2$ of PTFE by means of 3 dips through dilute TE-3313, each dip followed by drying and baking above the fusing temperature of PTFE. A 0.0007 inch film of PTFE, cast on stainless steel foil, was press laminated to each face of the coated KEVLAR fabric at 200-250 psi (calculated on the sample) at 700°F. for 3 minutes, between sheets of aluminum foil treated with silicone mold release. The resulting laminate consisted of continuous film of PTFE which completely covered the reinforcing KEVLAR yarns and spanned the very large openings of the woven textile. The film exhibited acceptable adhesion to the reinforcement, and the resulting composite was flexible and resistant to damage.

Example 14

Chemfab Style No. 1590 KEVLAR fabric was coated with PTFE and a cast film consisting of 60% by weight PTFE and 40% by weight terpolymer fluoroelastomer (VF/HFP/TFE), approximately 0.001-0.002 inches thick, was laminated to each face using the techniques and conditions of Example 13. The film was produced by casting on aluminum foil a composition made by combining 100 parts by weight of TE-3313 with 64 parts by weight of VTR-5307 latex (obtained from DuPont). Such compositions are discussed extensively in the copending U.S. application of Effenberger and Keese, Serial No. 484,594, filed April 13, 1983 and its continuation-in-part application filed April 13, 1984. The resulting product, while somewhat heavier than that of Example 13, was considerably more flexible. The KEVLAR reinforcement was protected by a continuous resinous film, which also completely bridged the openings in this very open textile mesh. The composite has a noticeably lower flexural modulus than its PTFE/KEVLAR counterpart.

Example 15

A laminated composite suitable for use in the manufacture of printed circuit boards was prepared from (a) silane treated copper foil, (b) cast films of a flexible fluoropolymer, and (c) a fiberglass substrate prepared by lightly coating it with FEP.

The copper foil employed was 3 mils thick (Yates Industries, Bordentown, N.J.; Type "A" etch), one face of which was treated with a 1% aqueous solution (w/v) of A-1100 Silane (Union Carbide Corp.) and air dried in an oven at 225°F. The treated face contacted the fluoropolymer films in preparation of the laminated composite.

The fluoropolymer films employed were prepared by casting a blend of PTFE and VF2/HFP/TFE elastomeric copolymer derived from aqueous latices (TE-3313 and VTR-5307 respectively, obtained from DuPont). The blend contained a 60:40 weight ratio of PTFE to fluoroelastomer. This blend was cast onto an aluminum foil initially coated with a light FEP layer derived from TE-9503 (DuPont) diluted to a specific gravity of 1.30. Overall film thickness was about 1 mil after baking at 590!F. and stripping from the aluminum foil.

The fiberglass substrate was a Style 128 fiberglass fabric dip coated with FEP derived from TE-9503 (55% solids) to a total weight of 8.4 oz/sq. yd. The fabric was heat-cleaned prior to coating. A laminate was prepared from these materials by alternately stacking the prepared fiberglass substrate and fluoropolymer containing film such that the top and bottom layers of the stack presented an FEP face to the copper foil deployed as the outermost components of the stack for lamination. Three layers of the fiberglass substrate were interleaved with four layers of film, and a foil layer was employed to create each outermost face. This stack was converted to a laminate by pressing for five minutes at 550°F. and ca. 500 psi and subsequently cooled under pressure. The resulting laminate was judged economically suitable for use as a printed circuit board intermediate.

While representative applications and embodiments of the invention have been described, those skilled in the art will recognize that many variations and modifications of such embodiments may be made without departing from the spirit of the invention, and it is intended to claim all such variations and modifications as fall within the true scope of the invention.

## Claims

1. A method for the manufacture of a composite including a substrate and a coating matrix, which comprises the steps of:

(a) separately forming a film comprising a fluoropolymer-containing material;

(b) treating the substrate where necessary to facilitate film adhesion and bonding;

(c) uniformly contacting at least one face of the film with a treated surface of the substrate; and

(d) transferring the film to the treated substrate with heat and pressure to obtain a uniform coated composite.

2. A method according to claim 1 wherein the film is formed by casting.

3. A method according to claim 2 wherein the film is prepared and transferred by a decalcomania process.

4. A method according to claim 2 wherein the film is cast upon a dimensionally stable support member.

5. A method according to claim 4 wherein the support member comprises a metal foil or a compatible polymeric film.

6. A method according to claim 1 wherein the substrate is any suitable reinforcement material capable of withstanding processing conditions.

7. A method according to claim 6 wherein the substrate is selected from the group comprising glass, fiberglass, ceramics, graphite (carbon), PBI (polybenzimidazole), PTFE, polyaramides, metal including metal mesh and wire, polyolefins, polyesters, polyamides, polyimides, thermaplastics, polyphenylene sulfide, polyether oxides, polyether sulfones, polyether ketones, novoloid phenolic fibers, cotton, asbestos and other natural as well as synthetic textiles.

8. A method according to claim 1 wherein the substrate is treated with a melt adhesive, such as FEP, PFA and PCTFE and its copolymers with $VF_2$.

9. A method according to claim 1 wherein the substrate is treated with a chemically reactive or contact adhesive.

10. A method according to claim 1 wherein the substrate is treated with a suitable coupling agent.

11. A method according to claim 1 wherein the matrix polymers of the film layer include a fluoroplastic, a fluoroelastomer or any blend or combination thereof.

12. A method according to claim 11 wherein the matrix contains mineral or polymeric fillers, or a combination thereof.

13. A method according to claim 12 wherein the polymeric filler is employed to form a thermally stable, wear resistant fiber or composite.

14. A method according to claim 1 wherein the film matrix is applied to the substrate in a nip-roll lamination.

15. A method for the manufacture of a composite including an otherwise incompatible coating matrix and substrate, which comprises the steps of:

(a) preparing the substrate face or faces with any processible polymer which facilitates adhesion to the coating matrix;

(b) separately forming a film comprising a fluoropolymer-containing coating matrix material through a graduation of polymer blends such that the matrix face of the film to be contacted with the prepared substrate is compatible with it;

(c) uniformly contacting said bondable surfaces of the substrate and graded film layer; and

(d) transferring the film to the prepared substrate with heat and pressure to obtain a uniform coated surface.

16. A method according to claim 15 wherein the transferred film comprises a multiplicity of layers of the same or different composition.

17. A method according to claim 16 wherein at least one film layer comprises a metal or metallized layer.

18. A composite prepared by the process comprising the steps of:

(a) separately forming a film comprising a fluoropolymer-containing material;

(b) treating the substrate to facilitate film adhesion and bonding;

(c) uniformly contacting at least one face of the film with a treated surface of the substrate; and

(d) transferring the film to the treated substrate with heat and pressure to obtain a uniform coated composite.

19. A composite according to claim 18 wherein the film is formed by casting.

20. A composite according to claim 19 wherein the film is prepared and transferred by a decalcomania process.

21. A composite according to claim 19 wherein the film is cast upon a dimensionally stable support member.

22. A composite according to claim 21 wherein the support member comprises a metal foil or a compatible polymeric film.

23. A composite according to claim 16 wherein the substrate is any suitable reinforcement material capable of withstanding processing conditions.

24. A composite according to claim 23 wherein the substrate is selected from the group comprising glass, fiberglass, ceramics, graphite (carbon), PBI (polybenzimidazole), PTFE, polyaramides, metal including metal mesh and wire, polyolefins, polyesters, polyamides, polyimides, thermaplastics, polyphenylene sulfide, polyether oxides, polyether sulfones, polyether ketones, novoloid phenolic fibers, cotton, asbestos and other natural as well as synthetic textiles.

25. A composite according to claim 18 wherein the substrate is treated with a melt adhesive, such as FEP, PFA and PCTFE and its copolymers with $VF_2$.

26. A composite according to claim 18 wherein the substrate is treated with a chemically reactive or contact adhesive.

27. A composite according to claim 18 wherein the substrate is treated with a suitable coupling agent.

28. A composite according to claim 18 wherein the matrix polymers of the film layer include a fluoroplastic, a fluoroelastomer or any blend or combination thereof.

29. A composite according to claim 28 wherein the matrix contains mineral or polymeric fillers, or a combination thereof.

30. A composite according to claim 29 wherein the polymeric filler is a thermally stable, wear resistant polymer material.

31. A composite according to claim 18 wherein the film mixture is applied to the substrate by a nip-roll lamination.

32. A composite for the manufacture of a composite including an otherwise incompatible coating matrix and substrate, which comprises the steps of:

(a) preparing the substrate face or faces with any processible polymer which facilitates adhesion and bonding to the coating matrix;

(b) separately forming a film comprising a fluoropolymer containing coating matrix material through a graduation of polymer blends such that the matrix face of the film to be contacted with the prepared substrate is compatible with it;

(c) uniformly contacting the said bondable surfaces of the substrate and graded film layer; and

(d) transferring the film to the prepared substrate with heat and pressure to obtain a uniform coated surface.

33. A composite according to claim 18 wherein the transferred film comprises a multiplicity of layers of the same or different compositions.

34. A composite according to claim 33 wherein at least one film layer comprises a metal or metallized layer.

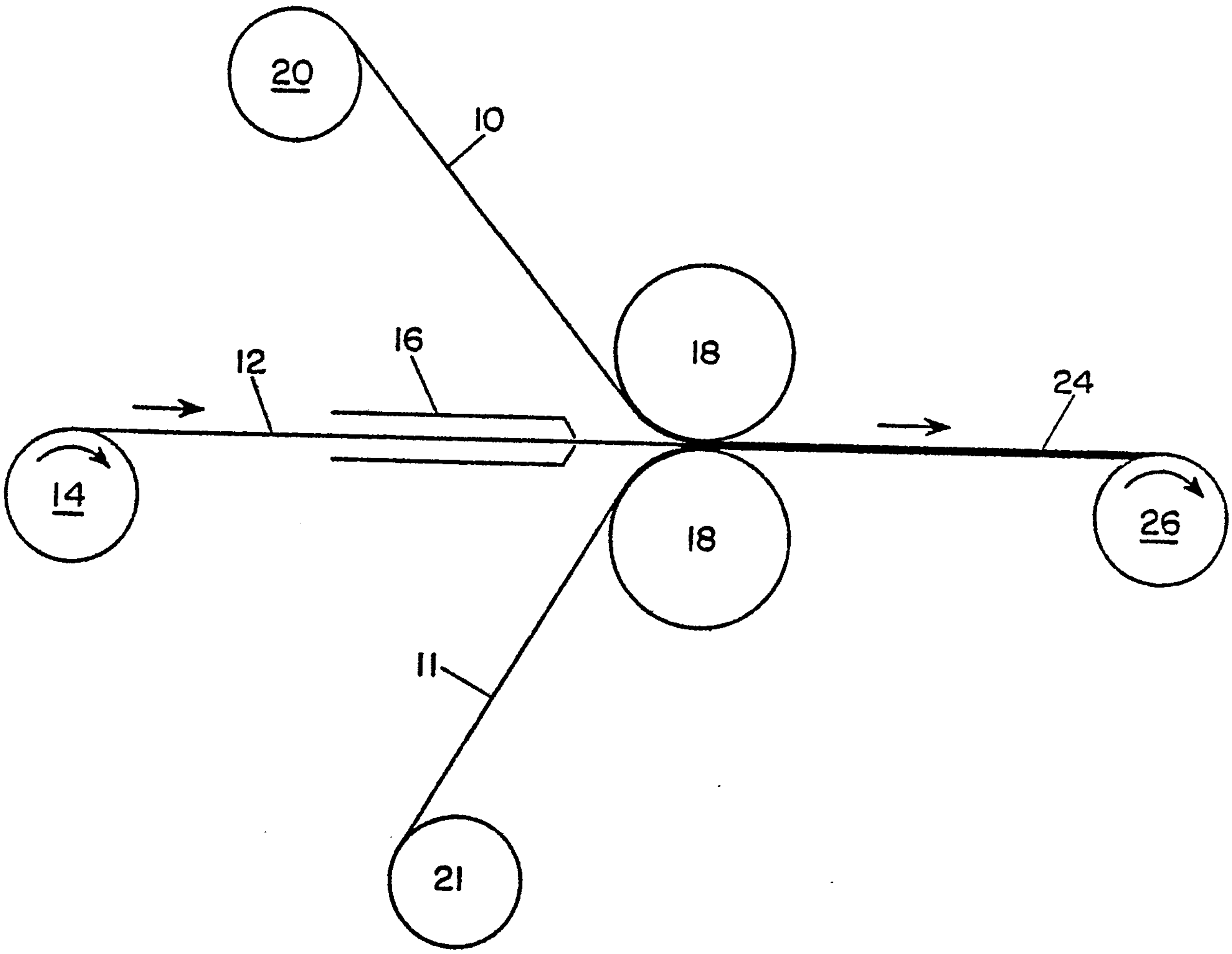


FIG. 1

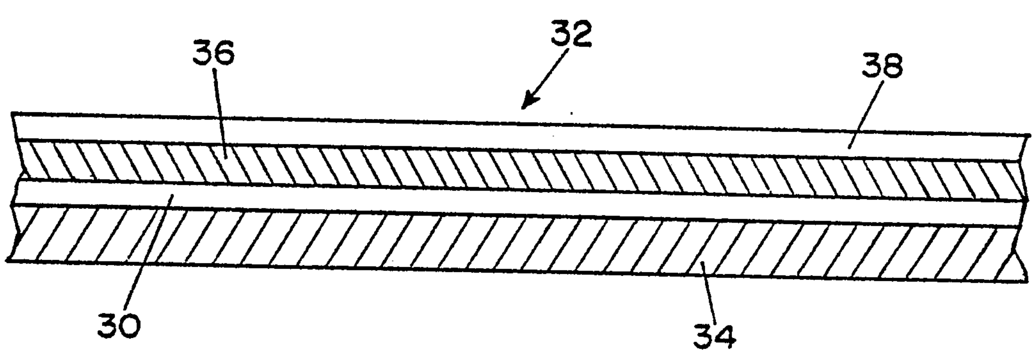


FIG. 2

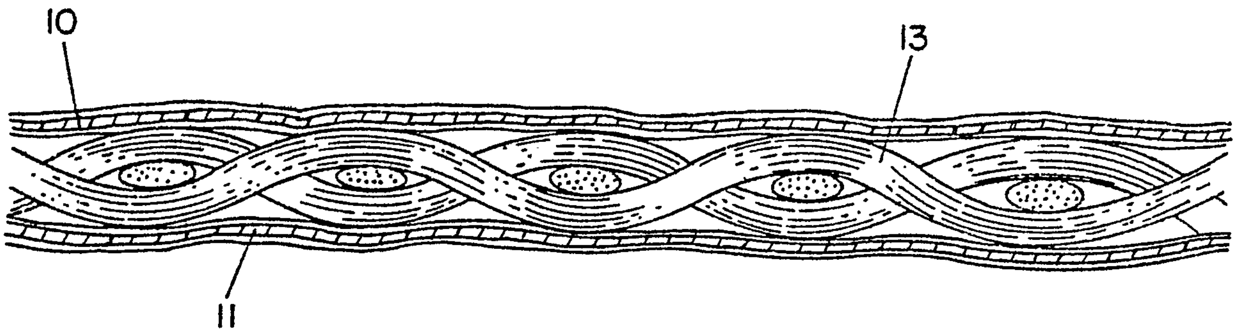
10
13
11

FIG. 3

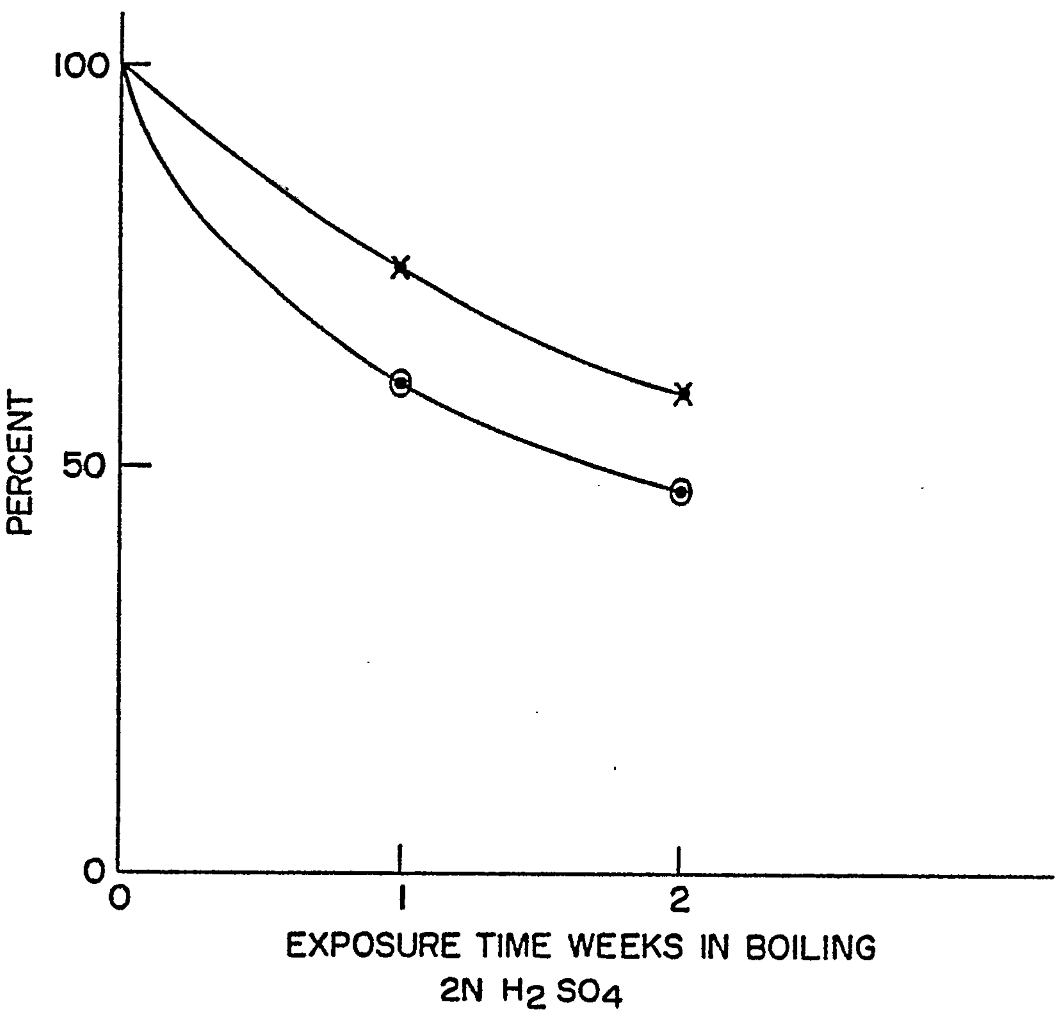
100
50
0
PERCENT
0
1
2
EXPOSURE TIME WEEKS IN BOILING
2N $H_2SO_4$

FIG. 4